(19) Europäisches Patentamt
European Patent Office
Office européen des brevets

(11) EP 2 986 993 B1

(12) **EUROPEAN PATENT SPECIFICATION**

(45) Date of publication and mention
of the grant of the patent:
**07.03.2018 Bulletin 2018/10**

(21) Application number: **14732822.3**

(22) Date of filing: **15.04.2014**

(51) Int Cl.:
*G01R 31/34* *(2006.01)*   *G01R 31/02* *(2006.01)*
*G01R 31/14* *(2006.01)*   *G01R 31/12* *(2006.01)*

(86) International application number:
**PCT/EP2014/057586**

(87) International publication number:
**WO 2014/170306 (23.10.2014 Gazette 2014/43)**

(54) **METHOD AND DEVICE FOR DETERMINING POWER SYSTEM PARAMETERS**

VERFAHREN UND VORRICHTUNG ZUR BESTIMMUNG VON STROMSYSTEMPARAMETERN

PROCEDE ET DISPOSITIF POUR DETERMINER DES PARAMETRES DE SYSTEME
D'ALIMENTATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.04.2013 SE 1300282**

(43) Date of publication of application:
**24.02.2016 Bulletin 2016/08**

(73) Proprietor: **Megger Limited
Dover,
Kent CT17 9EN (GB)**

(72) Inventors:
• **WERELIUS, Peter
S-186 70 Brottby (SE)**

• **ÖHLEN, Mats
S-114 20 Stockholm (SE)**
• **PURTON, Alan Lyle
Folkestone
Kent CT18 7LG (GB)**

(74) Representative: **Bergenstråhle Group AB
P.O. Box 17704
118 93 Stockholm (SE)**

(56) References cited:
**US-A- 6 051 980     US-A1- 2011 254 564
US-B1- 7 659 728**

**Description**

Technical field

The present invention relates generally to measuring and determining a dielectric parameter of an electrical insulation of a power system component and more particularly a method and a device for determining parameters taking into account the characteristics of the individual insulation properties.

Background art

Testing the insulation system of power system components, such as transformers, rotating machines and cables, may be conducted by connecting a test set to two conductors separated by an insulation system and exciting one conductor with the other conductor as a reference with electrical signals, either with a DC signal, an AC signal or an arbitrary waveform signal. Methods and apparatuses for measuring the degradation of the insulation of electrical power devices are known, like those ones of US 7,659,728 B1.
It is known that an increase in temperature causes a decrease of the insulation resistance. Therefore, the temperature has a high influence on insulation resistance measurements and the results should be corrected to a base temperature. The base temperature is normally in range of 15-40°C, e.g. 20°C.
It is also known to use tables with temperature correction factors with standard values for correcting the results to a base temperature. However, these factors do not take into account the characteristics of the insulation properties, which may change with aging status of the specific apparatus.

Summary of invention

An object of the present invention is to provide a method and a device for determining power system insulation parameters, wherein the individual characteristics of the power system apparatus insulation is taken into account.
According to a first aspect of the invention there is provided a method for determining a dielectric parameter of an electrical insulation of a power system component, comprising the following steps: determining the activation energy of the electrical insulation, determining the actual temperature of the electrical insulation and the temperature to which the measurement is to be corrected, calculating a correction factor by means of the Arrhenius equation, stimulating the electrical insulation with a DC voltage stimulation signal; determining a response for the power system to the DC voltage stimulation signal at the actual temperature, and determining the parameter of the electrical insulation at the temperature to which the measurement is to be corrected based on the response modified by means of the correction factor. Thereby, the individual characteristics of the power system apparatus insulation is taken into account.
In a preferred embodiment, the step of determining the parameter of the electrical insulation is performed in the frequency domain.
In a preferred embodiment, the frequencies are shifted by the correction factor.
In a preferred embodiment, the step of determining the parameter of the electrical insulation is performed in the time domain.
In a preferred embodiment, the time is shifted by the correction factor and the amplitude is scaled for the insulation resistance/ current reading by the correction factor.
In a preferred embodiment, the electrical insulation comprises one single material, and wherein the parameter of the electrical insulation is determined based on the response modified by means of the correction factor calculated based on one single activation energy.
In a preferred embodiment, the electrical insulation comprises at least two materials.
In a preferred embodiment, the steps of conducting a measurement of dielectric response as function of time at the actual temperature of the electrical insulation, and dividing the measurement data into data for first, second, and any further material.
In a preferred embodiment, the step of dividing the measurement data into data for first, second, and any further material is performed by means of a mathematical model, preferably the XY model for dielectric frequency response measurements.
In a preferred embodiment, the temperature correction is used for each material, the method comprising the additional step of determining the total dielectric response at the temperature to which the measurement is to be corrected.
In a preferred embodiment, the dielectric parameter is any of the following: insulation resistance, dielectric absorption ratio, and polarisation index.
In a preferred embodiment, the power system component is any of the following: a rotating machine, a transformer, a bushing and a power cable.
In a preferred embodiment, a correction is performed for several temperatures in an interval for determining the temperature dependence of the dielectric parameter, preferably insulation resistance and polarisation index.

According to a second aspect of the invention there is provided a device for determining a dielectric parameter of an electrical insulation of a power system component, comprising a test controller, a stimulator circuit adapted to stimulate the insulation of the power system component, a detector circuit adapted to detect, record, and/or measure the response of the power system component, an input device adapted to input test values and/or parameter values to command the stimulator circuit, and an output device, wherein the device is , characterized in that the test controller is adapted to control the device to perform the method according to the invention.

According to a third aspect of the invention there is provided a computer program, comprising computer readable code means, which when run in a device causes the device to perform the above mentioned method.

According to a fourth aspect of the invention there is provided a computer program product comprising a computer program comprising computer readable code means, which when run in a device causes the device to perform the above mentioned method.

Brief description of drawings

The invention is now described, by way of example, with reference to the accompanying drawings, in which:

Fig. 1 is a block diagram showing a device according to the invention for determining power system parameters;

Fig. 2 is a diagram showing possible temperature dependence of a material when measured in frequency domain;

Fig. 3 is a diagram showing possible temperature dependence of a material when measured in time domain;

Fig. 4 is a diagram showing dissipation factor as a function of frequency;

Fig. 5 is a diagram showing insulation resistance as a function of time; and

Fig. 6 is a diagram showing insulation resistance at 60 seconds as a function of temperature.

Description of embodiments

In the following, a detailed description of a method and a device for determining a parameter of a power system component will be given.

Temperature dependence in many insulating materials can be described by the Arrhenius equations:

$$A_{xy}(T_1, T_2) = A_x(T_1, T_2) = A_y(T_1, T_2) = e^{\frac{-E_{x,y}}{k_b}\left(\frac{1}{T_2} - \frac{1}{T_1}\right)} \qquad (1)$$

wherein $k_b$ is Boltzmans constant = $1.3806488 \times 10^{-23}$ $m^2$ kg $s^{-2}K^{-1}$ and $E_{xy}$ is the activation energy, e.g. 0.90 eV (1 eV (electron volt) = $1.60217657 \times 10^{-19}$ joules)
Assume the activation energy = 0.90 eV and T1 =40°C (=313.15K) and T2=20°C (=293.15K), then

$$A_{xy}(313.15, 293.15) = e^{\frac{-0.90 \times 1.602 \times 10^{-19}}{1.381 \times 10^{-23}}\left(\frac{1}{293.15} - \frac{1}{313.15}\right)} = 0.103$$

A correction in the frequency domain, where $\omega$ represents the frequency, is performed as follows.

$$\chi(\omega, T_2) = A_y/A_x * \chi(\omega/A_x(T1, T2), T_1)$$

For insulation materials that follow the Arrhenius equation, $A_x = A_y = A_{xy}$ and then:

$$\chi(\omega, T_2) = \chi(\omega/A_x(T1, T2), T_1) \qquad (2)$$

wherein $\chi(\omega, T)$ represents the contribution to real and to imaginary part permittivity of a single polarization process. For most insulation materials, if the conductivity can be neglected, usually one polarization process dominates the losses and the method is valid also for the measured dissipation factor (DF), i.e.:

$$DF(\omega, T_2) = DF(\omega/A_x(T1, T2), T_1) \qquad (3)$$

If DF is to be corrected to 50 Hz and 20°C from a measurement at T1 =40°C, then the measuring is conducted at about 485 Hz (50/0.103=485Hz). Measured DF at T1 =40°C is then corrected back:

$$DF(2*\pi*50, 293.15) = DF(2*\pi*50/0.103, 313.15)$$

Or, since in this formula angle frequency/frequency, temperature in Celsius/Kelvin scale the same

$$DF(50, 20) = DF(50/0.103, 40) = DF(485, 40)$$

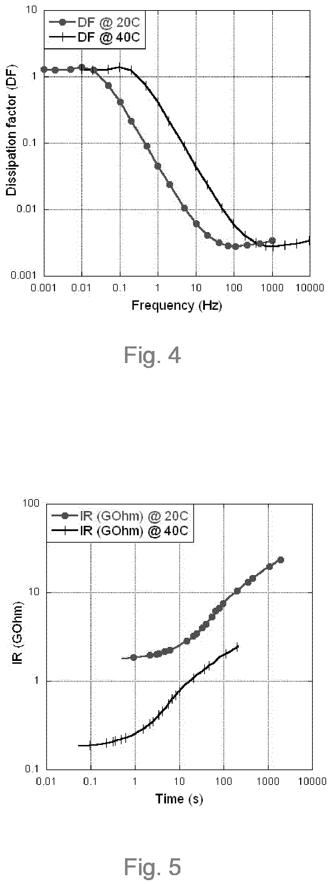

DF, e.g. 0.0023, measured at T1 =40°C and at frequency 485 Hz is the same as DF at frequency 50 Hz for temperature T2=20°C (i.e. also e.g. 0.0023). This is exemplified in Fig. 4, showing the dissipation factor as a function of frequency. It is there seen how the dissipation measured at 40°C is adjusted by means of the Arrhenius or correction factor to obtain the dissipation factor at 20°C.

A correction in the time domain is performed as follows.

$$f(t, T2)=A_y(T1, T2)*f(A_x(T1,T2)*t, T1)$$

For insulation materials that follow the Arrhenius equation, $A_x=A_y=A_{xy}\square$ and then

$$f(t, T2)=A_{xy}(T1, T2)*f(A_{xy}(T1,T2)*t, T1) \qquad (4)$$

wherein f(t, T) represents the contribution to current, scaled by voltage and geometry of the sample, of a single polarization process. For most insulation materials, if the conductivity can be neglected, usually one polarization process dominates the current in time interval of interest and therefore

$$I(t, T2)=A_{xy}(T1, T2)*I(A_{xy}(T1,T2)*t, T1) \qquad (5)$$

The insulation resistance (IR) is defined as IR(t, T2) = U / I(t, T2) where U is kept constant. Therefore

$$IR(t, T2)=1/A_{xy}(T1, T2)*IR(A_{xy}(T1,T2)*t, T1) \qquad (6)$$

If IR is to be corrected to 60 s and 20°C, then measuring of the insulation resistance is done at about 6.2 s (0.103*60=6.2). Measured data at T1 =40°C is then corrected back:

$$IP(60, 293.15)=1/0.103*IP(0.103*60, 313.15)$$

or since temperature in Celsius/Kelvin scale the same

$$IP(60, 20)=1/0.103*IP(0.103*60, 40)$$

IR, e.g. 1.0 GOhm, measured at T1 =40°C and at a time 6.2 s is the same as IR = 9.7 GOhm (1.0 GOhm / 0.103) at time = 60 s for temperature T2 = 20°C.

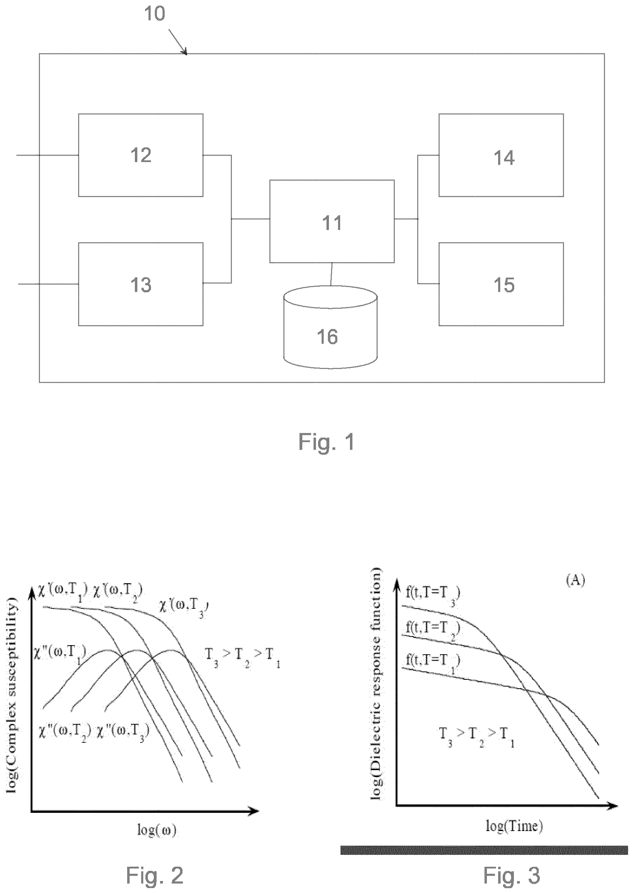

Turning now to Fig. 1, a device for determining insulation parameters, generally designated 10, is shown. The device 10 comprises a test controller 11, a stimulator circuit 12, a detector circuit 13, an input device 14, an output or display device 15, and an optional database 16. The device may be connected to an electrical power system apparatus by means of a harness or the like (not shown).

The test controller 11 may comprise a computer program, comprising computer readable code means, which when run in a device causes the device to perform the method as described below. Also the test controller may comprise a computer program product comprising such a computer program.

The stimulator circuit 12 stimulates or excites the insulation of the power system component under test with a stimulation signal. For example, the stimulator circuit 12 may generate a direct current (DC) voltage signal to stimulate the component under test.

The detector circuit 13 detects, records, and/or measures the response of the component under test to the stimulation signal output by the stimulator 12. The detector circuit 13 may include one or more analogue-to-digital converters to periodically capture the voltage and/or current of an output of the component under test and other circuitry to store the digital values in a memory. In an embodiment, the detector circuit 13 may include other circuitry or processing functionality to analyze the captured response to determine a test result parameter, for example polarization current, depolarization current, insulation resistance, dielectric absorption ratio and polarization index. Alternatively, the detector circuit 13 provides unprocessed data to the test controller 11, which analyzes the unprocessed data to determine the test result parameter.

The test controller 11 conducts the test by controlling the stimulator circuit 12 and the detector circuit 13. The test controller 11 receives inputs from the input device 14 that the test controller 11 uses to define test values and/or parameter values to command the stimulator circuit 12. The inputs may define an insulation temperature of the power system component under test and/or an ambient temperature of the environment surrounding the power system component under test.

The input device 14 may be a keyboard and/or keypad and/or touch screen. The display device 15 may be a flat panel display, a liquid crystal display (LCD), or other display.

The device 10 may be coupled to local AC power and to a printer at the test location, in the field, to print out test results on location.

A method for determining a dielectric parameter of an electrical insulation of a power system component will now be described in detail. The method described in a general way comprises the following steps. Although these steps are described in a specific order, it will be appreciated that the order may be changed without deviating from the inventive idea.

The testing is assumed to be performed at the temperature T1, i.e., the actual specimen temperature, while in the following the temperature you would like to "correct" your measured data to, is designated T2.

The activation energy Exy of the electrical insulation of the power system component to be tested is determined. The activation energy is about 0.9 eV for oil-impregnated cellulose, such as Kraft paper and pressboard, and is about 0.4-0.5 eV for transformer oils. The activation energy for other materials can be found in literature or by measurements.

The actual temperature T1 of the electrical insulation is also determined. This can be done in many ways known to the person skilled in the art. The temperature T2 to which the measurement is to be corrected is also determined. Commonly, T2 = 40°C for rotating machines and T2 = 20°C for transformers while T2 = 16°C (60 °F) for cables.

Using the values of Exy, T1, and T2 in the Arrhenius equation, the temperature dependence or Arrhenius factor $A_{xy}$ (T1, $T_2$) used as a correction factor is calculated.

The electrical insulation is stimulated with a DC voltage stimulation signal for a suitable time, such as 6.2 seconds, 60 seconds or any other suitable time. The response of the electrical insulation to the DC voltage stimulation signal is then determined. Finally, based on the response, modified using the correction factor, the parameter of a power system component is determined.

Fig. 2 depicts possible temperature dependence of a material when measured in frequency domain (AC). In frequency domain the frequencies are shifted by the factor Axy calculated by Arrhenius equation based on T1 and T2 and the activation energy for the specific insulation material.

For example, if an oil-impregnated insulation system measured at 40°C has a dissipation factor of 0.0021 at 50 Hz and about 0.0028 at 485Hz it will have about 0.0028 at 50Hz and 20°C. 20°C difference means approximately a factor of 1/0.103 in frequency for an insulation material with activation energy of 0.9eV.

Fig. 3 depicts possible temperature dependence of a material when measured in time domain (DC). In time domain the same scaling factor is used as the one used in the frequency domain but the time is shifted and the amplitude is scaled for the insulation resistance / current reading.

For example, the same oil-impregnated insulation system as above is measured at 40°C. For a measurement result of e.g. 1 GOhm at time 6.2 s, the equivalent reading now is 9.7 GOhm (1 GOhm/0.103) at 60 seconds (6.2/0.103) for 20°C. In other words, if an insulation resistance reading at a specific time is of interest, e.g. at 60 s at 20°C, and the insulation temperature is not 20°C, the insulation resistance is measured at another time, wherein the scaling factor is determined by the temperature difference T1 - T2 and the activation energy and the insulation resistance/current is multiplied/divided with same scaling factor. This is exemplified in Fig. 5, wherein the insulation resistance is show as a function of time. The lower curve is the insulation resistance measured at 40°C and by adjusting it in time and scaling it with the Arrhenius or correction factor, the upper curve is obtained representing the insulation resistance at 20°C.

In the example above, wherein the electrical insulation comprises one single material, the parameter of the electrical insulation at T2 is determined based on the response modified by means of the correction factor for the single material, i.e., with one single activation energy. If the electrical insulation comprises two or more materials, the method must be applied individually for each of the two or more materials according to the following.

First, a dielectric parameter, insulation resistance (IR), polarisation current or depolarisation current, is measured in a time interval at the actual temperature of the insulation, T1, and dielectric response is obtained as a function of time. Then, by means of a model, such as the known XY model for dielectric frequency response measurements, the measurement data is divided into data for first, second, and any further material.

Using the Arrhenius factor for each material, it is determined how the response is to be transformed for a given temperature change to the temperature T2.

Finally, the total dielectric response is determined, using same model as when the materials were separated, e.g. the XY model, at the temperature to which the measurement is to be corrected.

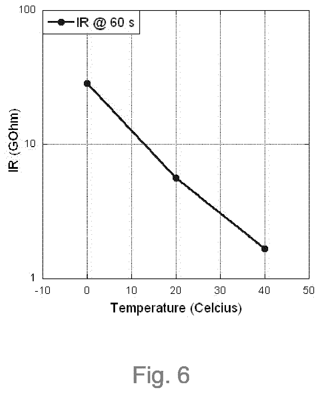

The result can be used as to calculate an equivalent dielectric parameter e.g. insulation resistance and polarisation index, for one single insulation material. Also, the dielectric response can be determined, e.g., insulation resistance and polarisation index, for a number of different temperatures and the dielectric response is plotted at for example insulation resistance at 60 seconds as a function of the temperature. This is exemplified in Fig. 6, showing the insulation resistance at 60 seconds as a function of temperature.

Preferred embodiments of a method and a device according to the invention have been described. It will be appreciated by one skilled in the art that the power system component test device may readily be employed for testing dielectric properties in power system components, including power transformers, instrument transformers, cables, generators, and other rotating machines, circuit breakers, and others, in some cases after making appropriate modifications to the stimulator circuit 12 or detector circuit 13 or test controller 11.

**Claims**

1. A method for determining a temperature dependency of a dielectric parameter of an electrical insulation of a power system component, comprising the following steps:

   - determining the activation energy of the electrical insulation,
   - determining the actual temperature (T1) of the electrical insulation and the temperature (T2) to which the measurement is to be corrected,
   - calculating a correction factor (Axy) by means of the Arrhenius equation,
   - stimulating the electrical insulation with a DC voltage stimulation signal;
   - determining a response for the power system to the DC voltage stimulation signal at the actual temperature, and
   - calculating the parameter of the electrical insulation at the temperature to which the measurement is to be corrected based on the response modified by means of the correction factor.

2. The method according to claim 1, wherein the step of determining the parameter of the electrical insulation is performed in the frequency domain

3. The method according to claim 2, wherein the frequencies are shifted by the correction factor (Axy).

4. The method according to claim 1, wherein the step of determining the parameter of the electrical insulation is performed in the time domain.

5. The method according to claim 4, wherein the time is shifted by the correction factor (Axy) and the amplitude is scaled for the insulation resistance/ current reading by the correction factor (Axy).

6. The method according to any one of claims 1-5, wherein the electrical insulation comprises one single material, and wherein the parameter of the electrical insulation is calculated based on the response modified by means of the correction factor calculated based on one single activation energy.

7. The method according to any one of claims 1-5, wherein the electrical insulation comprises at least two materials.

8. The method according to claim 7, comprising the steps of conducting a measurement of dielectric response as function of time at the actual temperature (T1) of the electrical insulation, and dividing the measurement data into data for first, second, and any further material.

9. The method according to claim 8, wherein the step of dividing the measurement data into data for first, second, and any further material is performed by means of a mathematical model, such as the XY model for dielectric frequency response measurements.

10. The method according to claim 8 or 9, wherein the temperature correction is used for each material, the method comprising the additional step of determining the total dielectric response at the temperature to which the measurement is to be corrected.

11. The method according to any one of claims 1-10, wherein the dielectric parameter is any of the following: insulation resistance, dielectric absorption ratio, and polarisation index.

12. The method according to any one of claims 1-11, wherein the power system component is any of the following: a rotating machine, a transformer, a bushing and a power cable.

13. The method according to any one of claims 1-12, wherein a correction is performed for several temperatures in an interval for determining the temperature dependence of the dielectric parameter, preferably insulation resistance and polarisation index.

14. A device for determining a temperature dependency of a dielectric parameter of an electrical insulation of a power system component, comprising a test controller (11), a stimulator circuit (12) adapted to stimulate the insulation of the power system component, a detector circuit (13) adapted to detect, record, and/or measure the response of the power system component, an input device (14) adapted to input test values and/or parameter values to command the stimulator circuit (12), and an output device (15), **characterized in that** the test controller (11) is adapted to control the device to perform all the steps of the method according to claim 1.

15. A computer program, comprising computer readable code means, which when run in a device causes the device to perform all the steps of the method according to any of claims 1-13.

16. A computer program product comprising a computer program according to claim 15.

**Patentansprüche**

1. Verfahren zum Bestimmen einer Temperaturabhängigkeit eines dielektrischen Parameters einer elektrischen Isolierung einer Energiesystemkomponente, umfassend die folgenden Schritte:

    - Bestimmen der Aktivierungsenergie der elektrischen Isolierung,
    - Bestimmen der tatsächlichen Temperatur (T1) der elektrischen Isolierung und der Temperatur (T2), auf welche die Messung korrigiert werden soll,
    - Berechnen eines Korrekturfaktors (Axy) mittels der Arrhenius-Gleichung,
    - Stimulieren der elektrischen Isolierung mit einem Gleichspannungs-Stimulationssignal;
    - Bestimmen einer Antwort für das Energiesystem auf das Gleichspannungs-Stimulationssignal bei der tatsächlichen Temperatur und
    - Berechnen des Parameters der elektrischen Isolierung bei der Temperatur, auf welche die Messung korrigiert werden soll, basierend auf der Antwort, die Mittels des Korrekturfaktors modifiziert wurde.

2. Verfahren nach Anspruch 1, wobei der Schritt des Bestimmens des Parameters der elektrischen Isolierung in der Frequenzdomäne durchgeführt wird.

3. Verfahren nach Anspruch 2, wobei die Frequenzen um den Korrekturfaktor (Axy) verschoben werden.

4. Verfahren nach Anspruch 1, wobei der Schritt des Bestimmens des Parameters der elektrischen Isolierung in der Zeitdomäne durchgeführt wird.

5. Verfahren nach Anspruch 4, wobei die Zeit um den Korrekturfaktor (Axy) verschoben wird und die Amplitude für den Isolierungswiderstands-/Stromwert durch den Korrekturfaktor (Axy) skaliert wird.

6. Verfahren nach einem der Ansprüche 1 bis 5, wobei die elektrische Isolierung ein einziges Material umfasst und wobei der Parameter der elektrischen Isolierung basierend auf der Antwort bestimmt wird, die mittels des Korrekturfaktors modifiziert wird, der basierend auf einer einzelnen Aktivierungsenergie berechnet wird.

7. Verfahren nach einem der Ansprüche 1 bis 5, wobei die elektrische Isolierung mindestens zwei Materialien umfasst.

8. Verfahren nach Anspruch 7, umfassend die Schritte des Durchführens einer Messung der dielektrischen Antwort als Funktion der Zeit bei der tatsächlichen Temperatur (T1) der elektrischen Isolierung und des Aufteilens der Messdaten in Daten für ein erstes, zweites und jedes weitere Material.

9. Verfahren nach Anspruch 8, wobei der Schritt des Aufteilens der Messdaten in Daten für ein erstes, zweites und jegliches weitere Material mittels eines mathematischen Modells, wie beispielsweise des XY-Modells für dielektrische Frequenzantwortmessungen, durchgeführt wird.

10. Verfahren nach Anspruch 8 oder 9, wobei die Temperaturkorrektur für jedes Material verwendet wird, wobei das Verfahren den zusätzlichen Schritt des Bestimmens der gesamten dielektrischen Antwort bei der Temperatur aufweist, auf welche die Messung korrigiert werden soll.

11. Verfahren nach einem der Ansprüche 1 bis 10, wobei der dielektrische Parameter einer der Folgenden ist: Isolierungswiderstand, dielektrisches Absorptionsverhältnis und Polarisationsindex.

12. Verfahren nach einem der Ansprüche 1 bis 11, wobei die Energiesystemkomponente eine der Folgenden ist: eine rotierende Maschine, ein Transformator, eine Buchse und ein Stromkabel.

13. Verfahren nach einem der Ansprüche 1 bis 12, wobei eine Korrektur für eine Vielzahl von Temperaturen in einem Intervall zur Bestimmung der Temperaturabhängigkeit des dielektrischen Parameters, vorzugsweise Isolierungswiderstand und Polarisationsindex, durchgeführt wird.

14. Vorrichtung zur Bestimmung einer Temperaturabhängigkeit eines dielektrischen Parameters einer elektrischen Isolierung einer Energiesystemkomponente, umfassend ein Teststeuerungselement (11), eine Stimulatorschaltung (12), die zur Stimulation der Isolierung der Energiesystemkomponente eingerichtet ist, eine Detektorschaltung (13), die zum Erfassen, Aufzeichnen und/oder Messen der Antwort der Energiesystemkomponente eingerichtet ist, eine Eingabevorrichtung (14), die zur Eingabe von Testwerten und/oder Parameterwerten, um die Stimulatorschaltung (12) anzuweisen, eingerichtet ist, und eine Ausgabevorrichtung (15), **dadurch gekennzeichnet, dass das** Teststeuerungselement (11) eingerichtet ist, um die Vorrichtung zu steuern, um alle Schritte des Verfahrens nach Anspruch 1 durchzuführen.

15. Computerprogramm, das computerlesbare Codemittel umfasst, die, wenn sie in einer Vorrichtung ausgeführt werden, die Vorrichtung dazu veranlassen, alle Schritte des Verfahrens nach einem der Ansprüche 1 bis 13 durchzuführen.

16. Computerprogrammprodukt, umfassend ein Computerprogramm nach Anspruch 15.

**Revendications**

1. Procédé de détermination d'une dépendance à la température d'un paramètre diélectrique d'une isolation électrique d'un composant de système d'alimentation, comprenant les étapes suivantes :

- la détermination de l'énergie d'activation de l'isolation électrique,
- la détermination de la température réelle (T1) de l'isolation électrique et de la température (T2) à laquelle la mesure doit être corrigée,
- le calcul d'un facteur de correction (Axy) au moyen de l'équation d'Arrhénius,
- la stimulation de l'isolation électrique avec un signal de stimulation de tension de courant continu ;
- la détermination d'une réponse pour le système d'alimentation au signal de stimulation de tension de courant continu à la température réelle, et

- le calcul du paramètre de l'isolation électrique à la température à laquelle la mesure doit être corrigée sur la base de la réponse modifiée au moyen du facteur de correction.

2. Procédé selon la revendication 1, dans lequel l'étape de détermination du paramètre de l'isolation électrique est réalisée dans le domaine de fréquence.

3. Procédé selon la revendication 2, dans lequel les fréquences sont décalées par le facteur de correction (Axy).

4. Procédé selon la revendication 1, dans lequel l'étape de détermination du paramètre de l'isolation électrique est réalisée dans le domaine temporel.

5. Procédé selon la revendication 4, dans lequel le temps est décalé par le facteur de correction (Axy) et l'amplitude est mise à l'échelle pour la lecture de la résistance d'isolation/du courant par le facteur de correction (Axy).

6. Procédé selon l'une quelconque des revendications 1 à 5, dans lequel l'isolation électrique comprend un unique matériau, et dans lequel le paramètre de l'isolation électrique est calculé sur la base de la réponse modifiée au moyen du facteur de correction calculé sur la base d'une unique énergie d'activation.

7. Procédé selon l'une quelconque des revendications 1 à 5, dans lequel l'isolation électrique comprend au moins deux matériaux.

8. Procédé selon la revendication 7, comprenant les étapes de mise en oeuvre d'une mesure de réponse diélectrique en fonction du temps à la température réelle (T1) de l'isolation électrique, et de division des données de mesure en données pour un premier, un deuxième, et n'importe quel autre matériau supplémentaire.

9. Procédé selon la revendication 8, dans lequel l'étape de division des données de mesure en données pour un premier, un deuxième, et n'importe quel autre matériau supplémentaire est réalisée au moyen d'un modèle mathématique, tel que le modèle XY pour les mesures de réponse de fréquence diélectrique.

10. Procédé selon la revendication 8 ou 9, dans lequel la correction de température est utilisée pour chaque matériau, le procédé comprenant l'étape supplémentaire de détermination de la réponse diélectrique totale à la température à laquelle la mesure doit être corrigée.

11. Procédé selon l'une quelconque des revendications 1 à 10, dans lequel le paramètre diélectrique est l'un quelconque des suivants : la résistance d'isolation, le rapport d'absorption diélectrique, et l'indice de polarisation.

12. Procédé selon l'une quelconque des revendications 1 à 11, dans lequel le composant de système d'alimentation est l'un quelconque des suivants : une machine tournante, un transformateur, une traversée et un câble d'alimentation.

13. Procédé selon l'une quelconque des revendications 1 à 12, dans lequel une correction est réalisée pour plusieurs températures dans un intervalle pour déterminer la dépendance à la température du paramètre diélectrique, de préférence la résistance d'isolation et l'indice de polarisation.

14. Dispositif pour déterminer une dépendance à la température d'un paramètre diélectrique d'une isolation électrique d'un composant de système d'alimentation, comprenant un dispositif de commande de test (11), un circuit stimulateur (12) conçu pour stimuler l'isolation du composant de système d'alimentation, un circuit détecteur (13) conçu pour détecter, enregistrer, et/ou mesurer la réponse du composant de système d'alimentation, un dispositif d'entrée (14) conçu pour entrer des valeurs de test et/ou des valeurs de paramètre pour commander le circuit stimulateur (12), et un dispositif de sortie (15), **caractérisé en ce que** le dispositif de commande de test (11) est conçu pour commander le dispositif afin d'effectuer toutes les étapes du procédé selon la revendication 1.

15. Programme informatique, comprenant un moyen de code lisible par ordinateur qui, quand il est exécuté dans un dispositif, amène le dispositif à effectuer toutes les étapes du procédé selon l'une quelconque des revendications 1 à 13.

16. Produit de programme informatique comprenant un programme informatique selon la revendication 15.

Fig. 1

Fig. 2

Fig. 3

Fig. 4

Fig. 5

Fig. 6

**EP 2 986 993 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7659728 B1